# EUROPEAN PATENT APPLICATION

(11) **EP 4 626 179 A1**
(43) Date of publication of application: **01.10.2025**
(21) Application number: 25163967.0
(22) Date of filing: 14.03.2025
(51) Int. Cl.: H10D 84/83, H10D 84/01, H10D 84/03, H10D 30/00, H10D 30/01, H10D 64/01, H10D 62/10, H10D 64/27

(54) **FORKSHEET TRANSISTORS WITH SELF-ALIGNED DIELECTRIC SPINE**

(30) Priority: 25.03.2024 US 202418615372
(71) Applicant: INTEL Corporation, Santa Clara, CA 95054 (US)
(72) Inventor: KOH, Shao Ming, Mountain View, 94041 (US); CHANDHOK, Manish, Beaverton, 97006 (US); SCHENKER, Richard, Portland, 97229 (US); ZHU, Baofu, Portland, 97229 (US); WEBER, Cory E., Hillsboro, 97124 (US); TIWARI, Vishal, Hillsboro, 97123 (US); CHU, Tao, Portland, 97229 (US); YAUNG, Jack, Hillsboro, 97123 (US)
(74) Representative: 2SPL Patentanwälte PartG mbB

(57) **Abstract**

Techniques to form semiconductor devices that include forksheet transistors with a self-aligned dielectric spine. **In** an example, first and second semiconductor devices have first and second semiconductor regions, respectively, extending in a first direction between corresponding source or drain regions. The first and second semiconductor regions may include any number of nanosheets with first and second gate structures extending around three sides of each of the first and second semiconductor regions, respectively. A dielectric spine extends in the first direction directly between the first and second semiconductor regions. **In** an example, the gate dielectric of each of the first and second gate structures is still present between the first and second semiconductor regions and the dielectric spine. An uppermost width of the dielectric spine may be smaller (e.g., 5 nm or more smaller) than a lower width of the dielectric spine that is between the first and second gate structures.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that illustrate forksheet transistors with a self-aligned dielectric spine, in accordance with an embodiment of the present disclosure.
Figures 2A - 2L" are cross-sectional views that illustrate various stages in an example process for forming semiconductor devices having forksheet transistors with a self-aligned dielectric spine, in accordance with some embodiments of the present disclosure.
Figure 3 illustrates a cross-sectional view of a chip package containing one or more semiconductor dies as variously described herein, in accordance with some embodiments of the present disclosure.
Figure 4 is a flowchart of a fabrication process for semiconductor devices having forksheet transistors with a self-aligned dielectric spine, in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include forksheet transistors with a self-aligned dielectric spine. In an example, first and second semiconductor devices have first and second semiconductor regions, respectively, extending in a first direction between corresponding source and drain regions. A first gate structure extends in a second direction over the first semiconductor regions, and a second gate structure extends in the second direction over the second semiconductor regions. The first and second semiconductor regions may include any number of nanosheets, with the first and second gate structures extending around three sides of each of the first and second semiconductor regions, respectively. A dielectric spine extends in the first direction directly between the first and second semiconductor regions. The dielectric spine can be formed after the source and drain regions are formed, and after the final gate structures are formed. In an example, masking structures above each of the first and second semiconductor regions are used to define an opening at or near a midpoint between the first and second semiconductor regions through which a recess is formed through the gate structure. The recess is then widened and filled with one or more dielectric materials to form the dielectric spine. In an example, the gate dielectric of each of the first and second gate structures may still be present between the first and second semiconductor regions and the dielectric spine. The first and second mask structures may also still be present with the dielectric spine formed directly between them and beneath a portion of each of the first and second mask structures. Providing the first and second mask structures allows for self-aligned formation of the dielectric spine after formation of the gate structure, which enhances the integrity of the dielectric spine. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like gate cuts are used in integrated circuit design to isolate gate structures from one another. Another example is a dielectric spine of a forksheet transistor arrangement. Like the gate cut, the dielectric spine extends across a gate trench and separates gate structures on either side of the dielectric spine. However, the semiconductor regions of semiconductor devices on either side of the dielectric spine abut the sides of the dielectric spine, such that the gate does not extend completely around the semiconductor regions. This structure allows the forksheet transistors to be patterned very close together (e.g., with only the dielectric spine between them). However, due to the closely packed nature of the forksheet transistors, shorting can be a problem if the integrity of the dielectric spine degrades during fabrication. In more detail, the dielectric spine is formed fairly early in the fabrication process (just after fin formation), which requires protecting the dielectric material through several subsequent processing operations, such as source and drain processing that includes deposition and etch processes used to form internal gate spacers. But protecting the dielectric spine is challenging and the subsequent fabrication processes often result in portions of the dielectric spine being etched away. For instance, in cases where the internal gate spacer is the same material as the dielectric spine, the deposition and etch back (recessing) of the gate spacer material by way of the source and drain trenches (prior to epitaxial deposition) also can remove a top portion of the dielectric spine material, which in turn allows merging of epitaxial growth by the opposing source or drain regions.

Thus, and in accordance with an embodiment of the present disclosure, techniques are provided herein to form a self-aligned dielectric spine of forksheet transistors relatively late in the overall device fabrication process (e.g., after the formation of the final gate structures). According to some embodiments, two semiconductor fins of alternating semiconductor material are formed that run parallel to one another along a first direction and are relatively close to one another (e.g., within 20 nm of each other) along an orthogonal second direction. Each fin of semiconductor material will ultimately form a single transistor on each side of a forksheet arrangement. Various fabrication procedures are performed to form source or drain regions at the ends of the fins and to release nanoribbons (also referred to as nanosheets in the context of a forksheet architecture) within each of the fins that extend between the source or drain regions. A gate structure is also formed that crosses over the nanoribbons of each of the fins along the second direction. At this intermediate stage of the fabrication process, the two adjacent semiconductor devices resemble gate all around (GAA) devices that share a gate.

According to some embodiments, a dielectric cap is present over the nanoribbons of each of the two adjacent semiconductor devices. The dielectric cap may remain through the formation of the gate structure, and may have the same width (along the second direction) as the underlying nanoribbons. According to some embodiments, a series of fabrication operations are performed to replace the adjacent dielectric caps with wider dielectric mask structures that provide an opening between the mask structures at or near a midpoint between the two adjacent semiconductor devices along the second direction. A trench recess can then be formed by way of an anisotropic etch through the final gate structure beneath the opening and the presence of the dielectric mask structures allows for this recess to be self-aligned directly between the nanoribbons. According to some embodiments, the trench recess is then widened by way of an isotropic etch to remove any conductive gate material from between the nanoribbons. The etch process may be selective to the gate dielectric, such that the gate dielectric is exposed but left in place. The recess is subsequently filled with one or more dielectric materials to form the dielectric spine between the semiconductor devices. The semiconductor nanoribbons may now be referred to as nanosheets as one side of each of the nanoribbons are no longer gated (gate control in that area is removed along with gate electrode). Because the dielectric spine is formed between GAA devices after the formation of the gate structure, at least a portion of the gate dielectric may be present between the dielectric spine and the adjacent (abutting) nanosheets, according to some examples.

According to an embodiment, an integrated circuit includes a first semiconductor device and a second semiconductor device. The first semiconductor device has a first semiconductor material extending in a first direction between a first source or drain region and a second source or drain region, and a first gate structure extending in a second direction over the first semiconductor region. The second semiconductor device has a second semiconductor region extending in the first direction between a third source or drain region and a fourth source or drain region, and a second gate structure extending in the second direction over the second semiconductor region. The integrated circuit further includes a first mask structure above the first semiconductor material, a second mask structure above the second semiconductor material, and a dielectric spine between the first semiconductor material and the second semiconductor material and between the first gate structure and the second gate structure. The dielectric spine is also between the first mask structure and the second mask structure, and the dielectric spine contacts at least a portion of a lower surface of the first mask structure and at least a portion of a lower surface of the second mask structure.

According to an embodiment, an integrated circuit includes a first semiconductor material extending in a first direction from a first source or drain region to a second source or drain region, a first gate structure extending in a second direction over the first semiconductor material, a second semiconductor material extending in the first direction from a third source or drain region to a fourth source or drain region, a second gate structure extending in the second direction over the second semiconductor material, and a dielectric spine between the first semiconductor material and the second semiconductor material and between the first gate structure and the second gate structure. The first gate structure includes a first gate dielectric on the first semiconductor material and a first gate electrode on the first gate dielectric, and the second gate structure includes a second gate dielectric on the second semiconductor material and a second gate electrode on the second gate dielectric. The first gate dielectric is directly between the dielectric spine and the first semiconductor material, and the second gate dielectric is directly between the dielectric spine and the second semiconductor material. In some such example embodiments, the first and second gate dielectrics are each in contact with the dielectric spine.

According to another embodiment, a method of forming an integrated circuit includes forming a first fin comprising first semiconductor material and a first dielectric cap over the first semiconductor material, and forming a second fin comprising second semiconductor material and a second dielectric cap over the second semiconductor material, wherein the first fin and the second fin are adjacent and extend parallel to one another along a first direction. The method continues with forming a sacrificial gate over the first fin and the second fin along a second direction different from the first direction, forming first source or drain regions at opposite ends of the first fin and second source or drain regions at opposite ends of the second fin, and replacing the sacrificial gate with a gate structure that extends over the first semiconductor material and the second semiconductor material along the second direction. The method continues with recessing a top surface of the gate structure to form a recessed cavity adj acent to the first dielectric cap and second dielectric cap, forming a sacrificial material within the recessed cavity, removing the first dielectric cap and second dielectric cap to form first and second recesses respectively, widening the first and second recesses to form first and second widened recesses respectively, and forming first and second mask structures within the first and second widened recesses respectively. The method continues with forming a trench recess between the first and second mask structures and through the gate structure between the first semiconductor material and the second semiconductor material, widening the trench recess between the first semiconductor material and the second semiconductor material, and filling the trench recess with one or more dielectric materials (e.g., so as to form a dielectric spine of a forksheet transistor structure).

The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of dielectric mask structures above the nanosheets of adjacent forksheet transistors with the dielectric spine extending between the nanosheets and between the dielectric mask structures. In some cases, the width of the dielectric spine between the dielectric mask structures is smaller than the width of the dielectric spine between the gate structures (e.g., 5 to 15 nanometers smaller, or more). In some embodiments, such tools may indicate a high-k material (e.g., the gate dielectric) conformally around the nanosheets such that the high-k material is also present directly between the semiconductor nanosheets and the dielectric spine. In some such cases, the dielectric spine may be in direct contact with the gate dielectric. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

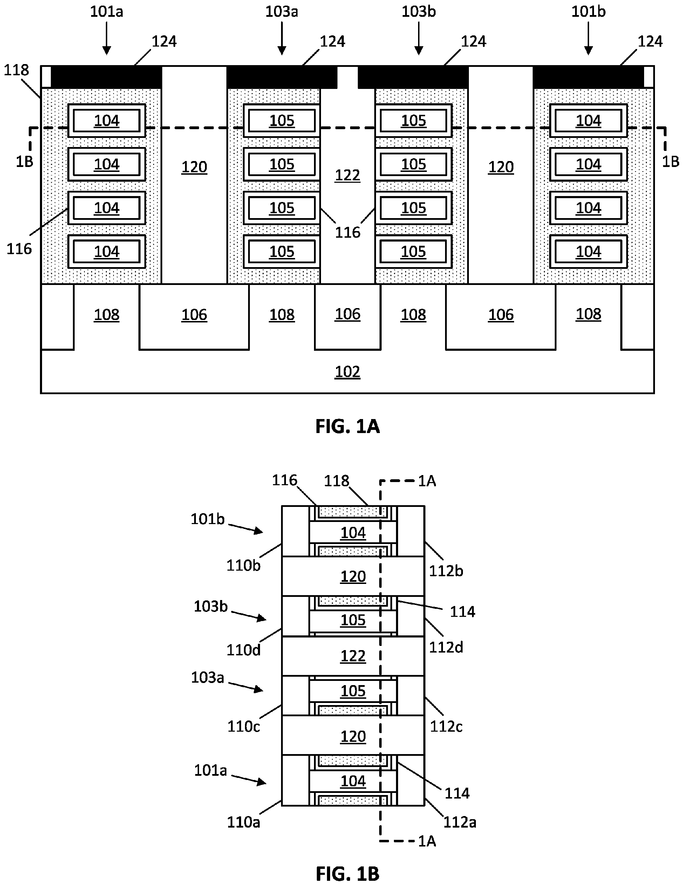

Figure 1A is a cross-sectional view taken across four example semiconductor devices 101a, 101b, 103a, and 103b, according to an embodiment of the present disclosure. Figure 1B is a top-down cross-section view of the semiconductor devices taken across the dashed line 1B-1B depicted in Figure 1A, and Figure 1A illustrates the cross-section taken across the dashed line 1A-1A depicted in Figure 1B. It should be noted that some of the material layers (such as mask structures 124) are not visible in the top-down view of Figure 1B, given the location of the depicted cross-section.

According to some embodiments, semiconductor devices 101a and 101b may be gate-all-around (GAA) transistors, and semiconductor devices 103a and 103b are part of a forksheet structure or arrangement having a dielectric spine 122. Other transistor topologies and types (e.g., finFETs, planar transistors) can also be used in conjunction with the forksheet techniques and structures provided herein. According to some embodiments, a given semiconductor device can be formed as either a GAA transistor or as part of a forksheet arrangement based on its distance from adjacent semiconductor devices. Those that are formed relatively close together (e.g., semiconductor devices 103a and 103b) may form a forksheet arrangement while those formed further apart from adjacent devices (e.g., semiconductor devices 101a and 101b) may form GAA transistors or finFETs (e.g., tri-gate or double-gate). Further details regarding the formation of semiconductor devices 101a, 101b, 103a, and 103b are provided herein. Semiconductor devices 101a, 101b, 103a, and 103b represent a portion of an integrated circuit that may contain any number of similar semiconductor devices.

As can be seen, the semiconductor devices are formed on a substrate 102. Any number of semiconductor devices can be formed on substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and/or power routing.

Each of semiconductor devices 101a and 101b includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. In a similar fashion, each of semiconductor devices 103a and 103b includes one or more nanosheets 105 that extend parallel to one another along the first direction between corresponding source and drain regions. In general, the term nanoribbons refer to semiconductor regions used in a GAA structure that have a gate wrapped around all sides of the semiconductor regions within the gate trench, and the term nanosheets refer to semiconductor regions used in a forksheet structure that have a gate wrapped around only some of the sides of the semiconductor regions within the gate trench (similar to a finFET laying on its side). The semiconductor material of nanoribbons 104 and nanosheets 105 may be formed from substrate 102. In some embodiments, semiconductor devices 101a, 101b, 103a, and 103b may each include fins with alternating layers of material (e.g., alternating layers of silicon and SiGe) that facilitates forming of the illustrated nanoribbons 104 and nanosheets 105 during a gate forming process where one type of the alternating layers is selectively etched away so as to liberate the other type of alternating layers within the channel region. The alternating layers can be blanket deposited and then etched into fins or deposited into fin-shaped trenches, according to some examples. In the examples shown, nanoribbons 104 and nanosheets 105 appear to have similar geometry. In other examples, nanoribbons 104 and nanosheets 105 may have different geometries, such as the example case where nanoribbons 104 are thicker (in the vertical direction) than nanosheets 105. In some such cases, nanosheets may be thinned during the gate formation process. In other such cases, the fins used to form nanoribbons 104 have a first geometry profile (configured to provide relatively taller nanoribbons), and nanosheets 105 have a second geometry profile (configured to provide relatively thinner nanosheets).

As can further be seen, adjacent semiconductor devices are separated by a dielectric fill 106 that may include silicon dioxide. Dielectric fill 106 provides shallow trench isolation (STI) between adjacent subfin regions 108 of any adjacent semiconductor devices. Dielectric fill 106 can be any suitable dielectric material, such as silicon dioxide, aluminum oxide, or silicon oxycarbonitride.

According to some embodiments, subfin regions 108 comprise the same semiconductor material as substrate 102 and are adjacent to dielectric fill 106. According to some embodiments, nanoribbons 104 (or other semiconductor bodies) extend between a source and a drain region in the first direction to provide an active region for a GAA transistor (e.g., the semiconductor region beneath the gate), and nanosheets 105 extend between a source and a drain region in the first direction to provide an active region for a forksheet transistor. The source and drain regions are not shown in the cross-section of Figure 1A, but are seen in the top-down view of Figure 1B where nanoribbons 104 of semiconductor device 101a extend between a source region 110a and a drain region 112a, nanoribbons 104 of semiconductor device 101b extend between a source region 110b and a drain region 112b, nanosheets 105 of semiconductor device 103a extend between a source region 110c and a drain region 112c, and nanosheets 105 of semiconductor device 103b extend between a source region 110d and a drain region 112d. Figure 1B also illustrates internal gate spacer structures 114 that extend around the ends of nanoribbons 104 and nanosheets 105 and along sidewalls of the gate structures so as to isolate the gate structures from the neighboring source or drain regions. Spacer structures 114 may include a dielectric material, such as silicon nitride.

According to some embodiments, the source and drain regions 110a-d, 112a-d are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions 110a-d, 112a-d may include multiple layers such as liners and capping layers to improve contact resistance. In any such cases, the composition and doping of the source and drain regions 110a-d, 112a-d may be the same or different, depending on the type (e.g., n-type or p-type) of the transistors. For example, one transistor may be a p-type MOS (PMOS) transistor, and another transistor may be an n-type MOS (NMOS) transistor. Any number of source and drain configurations and materials can be used.

According to some embodiments, gate structures extend over the nanoribbons 104 and nanosheets 105 of the different semiconductor devices. For example, a first gate structure extends over nanoribbons 104 of semiconductor device 101a along a second direction across the page, a second gate structure extends over nanoribbons 104 of semiconductor device 101b along the second direction, a third gate structure extends over nanosheets 105 of semiconductor device 103a along the second direction, and a fourth gate structure extends over nanosheets 105 of semiconductor device 103b along the second direction. The second direction may be orthogonal to the first direction (into and out of page, in Figure 1A). Each gate structure includes a respective gate dielectric 116 and a gate electrode (or gate layer) 118. Gate dielectric 116 represents any number of dielectric layers present between nanoribbons 104/nanosheets 105 and gate electrode 118. Gate dielectric 116 may also be present on the surfaces of other structures within the gate trench, such as on a top surface of subfin region 108. Gate dielectric 116 may include any suitable gate dielectric material(s). In some embodiments, gate dielectric 116 includes a layer of native oxide material (e.g., silicon dioxide) on the semiconductor regions 104, 105 making up the channel region of the devices, and a layer of high-k dielectric material (e.g., hafnium oxide) on the native oxide.

Gate electrode 118 may represent any number of conductive layers, such as any metal, metal alloy, or doped polysilicon layers. In some embodiments, gate electrode 118 includes one or more workfunction metals around nanoribbons 104 and nanosheets 105. In some embodiments, at least one of the semiconductor devices is a p-channel device that includes a workfunction metal having titanium around its nanoribbons 104 or nanosheets 105 and another semiconductor device is an n-channel device that includes a workfunction metal having tungsten around its nanoribbons 104 or nanosheets 105. Gate electrode 118 may also include a fill metal or other conductive material (e.g., tungsten, ruthenium, molybdenum, copper, aluminum) around the workfunction metals to provide the whole gate electrode structure.

According to some embodiments, adjacent gate structures may be separated along the second direction (e.g., across the page, left to right) by a gate cut 120, which acts like a dielectric barrier or wall between gate structures. Gate cut 120 extends vertically (e.g., in a third direction) through at least an entire thickness of the adjacent gate structure. In some embodiments, gate cut 120 also extends through an entire thickness of dielectric fill 106. According to some embodiments, gate cut 120 is formed from any number of dielectric materials. In some examples, gate cut 120 includes silicon nitride and may also include a core of silicon dioxide or silicon oxynitride. Gate cut 120 may have a top width along the second direction, for instance, between about 15 nm and about 30 nm.

According to some embodiments, adjacent semiconductor devices 103a and 103b are part of a forksheet arrangement with a dielectric spine 122 between them which similarly separates the adjacent gate structures around nanosheets 105 of each of semiconductor devices 103a and 103b. As shown, dielectric spine 122 extends vertically in the third direction through at least an entire thickness of the adjacent gate structures. Unlike gate cut 120, dielectric spine 122 is arranged close to nanosheets 105 along the second direction such that no part of gate electrode 118 exists between dielectric spine and the edges of nanosheets 105 along the second direction. In some embodiments, gate dielectric 116 wraps around all sides of nanosheets 105 such that gate dielectric 116 is arranged directly between dielectric spine 122 and nanosheets 105 along the second direction. Accordingly, gate dielectric 116 may directly contact both dielectric spine 122 and nanosheets 105. As further shown in this example, gate dielectric 116 does not extend continuously along sidewalls of dielectric spine 122, and in particular, is missing at the locations between nanosheets 105, such that dielectric spine 122 is also in direct contact with portions of gate electrode 118 around nanosheets 105.

Both gate cut 120 and dielectric spine 122 also extend in the first direction as seen in Figure 1B such that they each cut across at least the entire width of the gate trench. According to some embodiments, gate cut 120 and/or dielectric spine 122 may also extend further past spacer structures 114. In some examples, gate cut 120 and/or dielectric spine 122 extends across more than one gate trench in the first direction (e.g., cutting through more than one gate structure running parallel along the second direction).

According to some embodiments, mask structures 124 are present above each set of nanoribbons 104 and nanosheets 105. Masks structures 124 may be any suitable dielectric material, such as silicon nitride or silicon oxynitride. According to some embodiments, each mask structure 124 has a greater width along the second direction than a width of the underlying nanoribbons 104 or nanosheets 105. In some examples, a given mask structure 124 has a width along the second direction that is at least 5%, at least 10%, at least 15%, at least 25%, or at least 50% greater than a width of the underlying nanoribbons 104 or nanosheets 105. In some embodiments, mask structures 124 have a width along the second direction between about 25 nm and about 35 nm. According to some embodiments, mask structures 124 are used during the fabrication process to form a self-aligned recess through the gate electrode at or near the midpoint (any intermediate point) along the second direction between semiconductor devices 103a and 103b. The self-aligned recess can then be widened and filled with dielectric material to ultimately form the self-aligned dielectric spine 122, according to some embodiments. Through this process, dielectric spine 122 is formed after the formation of most other transistor elements (such as the gate structure and source or drain regions), which better maintains the integrity of the dielectric material used in dielectric spine 122 compared to situations where the dielectric spine is formed earlier in the fabrication process (e.g., before forming the gate structure). As shown, widening of the recess below the mask structures can cause the dielectric spine 122 to be wider in the second direction between the gate structures of devices 103a and 103b than between the masking structures 124 at the top of the recess. Likewise, widening of the recess below the mask structures can cause the dielectric spine 122 to be wider in the second direction between the nanosheets 105 of devices 103a and 103b than between the masking structures 124 at the top of the recess.

### Fabrication Methodology

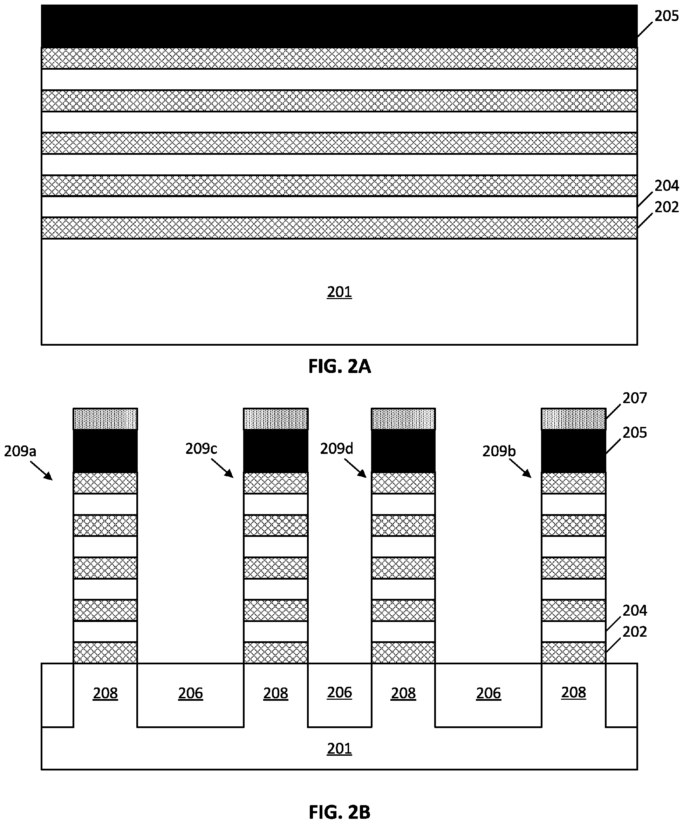

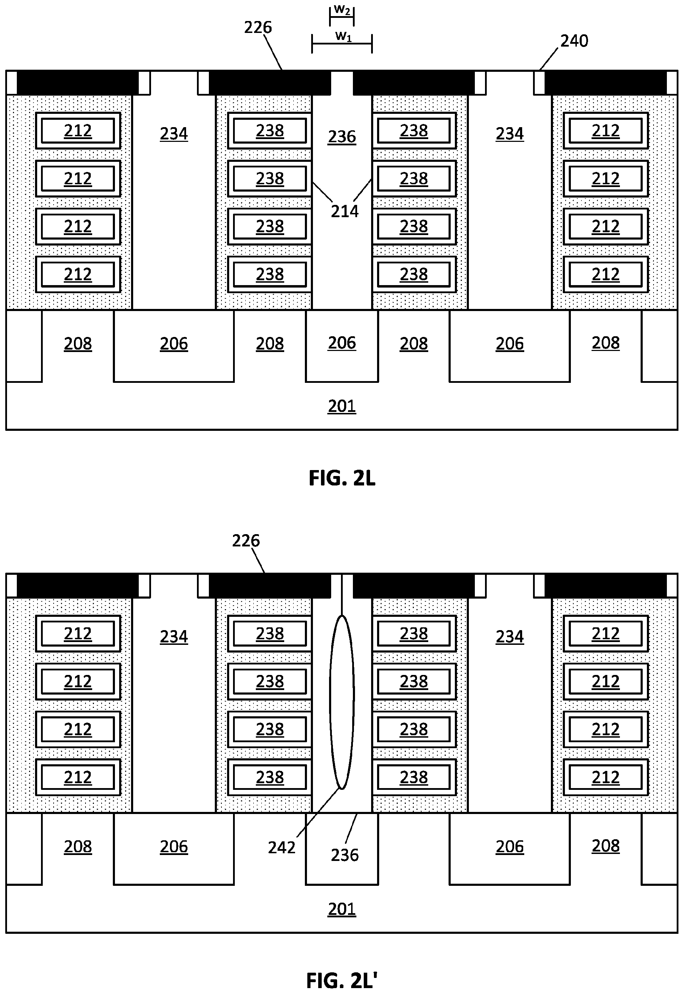

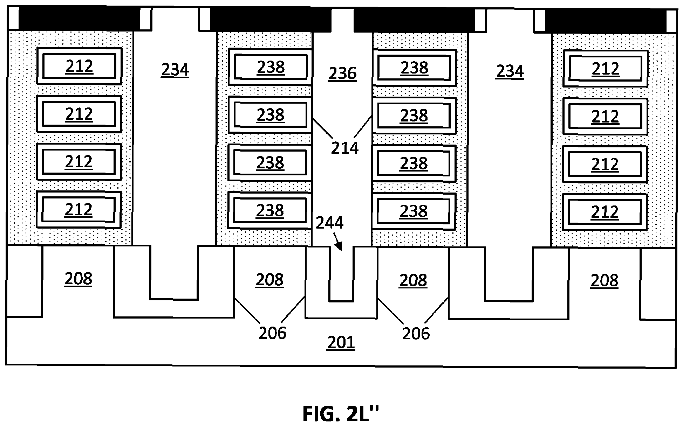

Figures 2A - 2L" include cross-sectional views that collectively illustrate an example process for forming an integrated circuit with semiconductor devices having a self-aligned forksheet dielectric spine formed through a gate structure, in accordance with an embodiment of the present disclosure. Each figure shows an example structure that results from the process flow up to that point in time, so the depicted structure evolves as the process flow continues, culminating in the structure shown in Figure 2L, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated. Although the fabrication of a single dielectric spine is illustrated in the aforementioned figures, it should be understood that any number of similar dielectric spines as part of forksheet structures can be fabricated across the integrated circuit using the same processes discussed herein.

Figure 2A illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA and forksheet transistor structures. Any number of alternating semiconductor layers 204 and sacrificial layers 202 may be deposited over substrate 201. The description above for substrate 102 applies equally to substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

According to some embodiments, a cap layer 205 is formed over the stack of alternating semiconductor layers 204 and sacrificial layers 202. Cap layer 205 may be any suitable dielectric material, such as silicon nitride or silicon oxynitride. Cap layer 205 may have a thickness that is generally the same as, or is at least as thick as, any of semiconductor layers 204 and sacrificial layers 202.

Figure 2B depicts the cross-section view of the structure shown in Figure 2A following the formation of a fin patterning layer 207 and the subsequent formation of fins 209a - 209d beneath fin patterning layer 207, according to an embodiment. Fin patterning layer 207 may be any suitable hard mask material such as a carbon hard mask (CHM) or any combination of material layers that can be easily removed following the etching process. Fin patterning layer 207 is patterned into rows to form corresponding rows of fins from the alternating layer stack of sacrificial layers 202 and semiconductor layers 204. The rows of fins extend lengthwise in a first direction (e.g., into and out of the page). Note that in the illustrated arrangement of fins, a distance between fins 209c and 209d is less than a distance between fin 209b and fin 209d and is less than a distance between fin 209a and fin 209c. In this example, fins 209c and 209d are patterned closer together to be part of a forksheet structure and fins 209a and 209b are patterned with a greater pitch between them and their neighboring fins to form GAA structures.

According to some embodiments, an anisotropic etching process through the layer stack continues into at least a portion of substrate 201. The etched portion of substrate 201 may be filled with a dielectric fill 206 that acts as shallow trench isolation (STI) between adjacent fins. Dielectric fill 206 may be any suitable dielectric material such as silicon dioxide. Subfin regions 208 represent remaining portions of substrate 201 between dielectric fill 206, according to some embodiments.

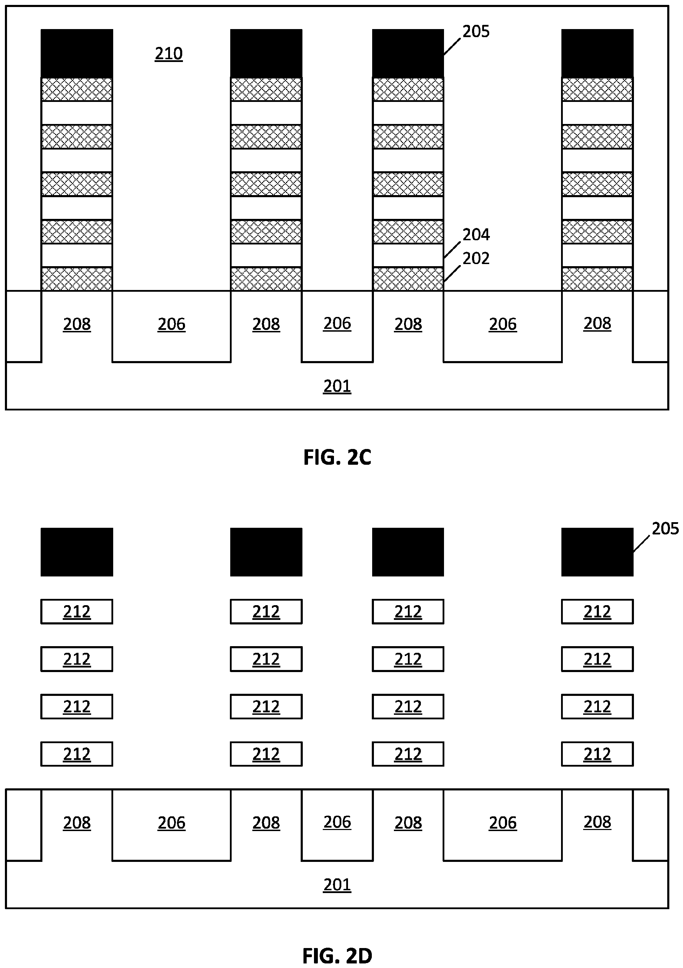

Figure 2C depicts the cross-section view of the structure shown in Figure 2B following the formation of a sacrificial gate 210 extending across the fins in a second direction different from the first direction, according to some embodiments. Sacrificial gate 210 may extend across the fins in a second direction that is orthogonal to the first direction. According to some embodiments, fin patterning layer 207 may be removed using any suitable isotropic etching technique prior to the formation of sacrificial gate 210. According to some embodiments, the sacrificial gate material is formed in parallel strips across the integrated circuit and removed in all areas not protected by a gate masking layer. Sacrificial gate 210 may be any suitable material that can be selectively removed without damaging the semiconductor material of the fins. In some examples, sacrificial gate 210 includes polysilicon. In some cases, sacrificial gate 210 may also include a dielectric liner, such as an oxide of the fin material, which covers the exposed surfaces of the fins.

Following the formation of sacrificial gate 210 (and prior to replacement of sacrificial gate 210 with a metal gate), additional semiconductor device structures are formed that are not shown in these cross-sections. These additional structures include spacer structures on the sidewalls of sacrificial gate 210 and source and drain regions on either ends of each of the fins. The formation of such structures can be accomplished using any number of processing techniques.

Figure 2D depicts the cross-section view of the structure shown in Figure 2C following the removal of sacrificial gate 210 and the removal of sacrificial layers 202, according to some embodiments. In examples where any gate masking layers are still present, they may also be removed at this time. Once sacrificial gate 210 is removed, the fins that had been beneath sacrificial gate 210 are exposed.

According to some embodiments, sacrificial layers 202 are selectively removed to release nanoribbons 212 that extend between corresponding source or drain regions. Each vertical set of nanoribbons 212 represents the semiconductor or channel region of a different semiconductor device. Sacrificial gate 210 and sacrificial layers 202 may be removed using the same isotropic etching process or different isotropic etching processes. According to some embodiments, one or more of the vertical sets of nanoribbons 212 includes a corresponding cap layer 205 above the nanoribbons. Due to the prior etching operations, the width of cap layer 205 along the second direction is substantially the same as a width of the underlying nanoribbons 212, according to some embodiments. In some embodiments, the outer two fins can be processed first, while the inner two fins are masked off. Then the outer two fins can be masked off and the inner two fins can be processed. In some such examples, after sacrificial layers 202 are removed from the inner two fins, nanoribbons 212 can be trimmed or thinned to provide nanosheets that are thinner than the nanoribbons of the outer two fins.

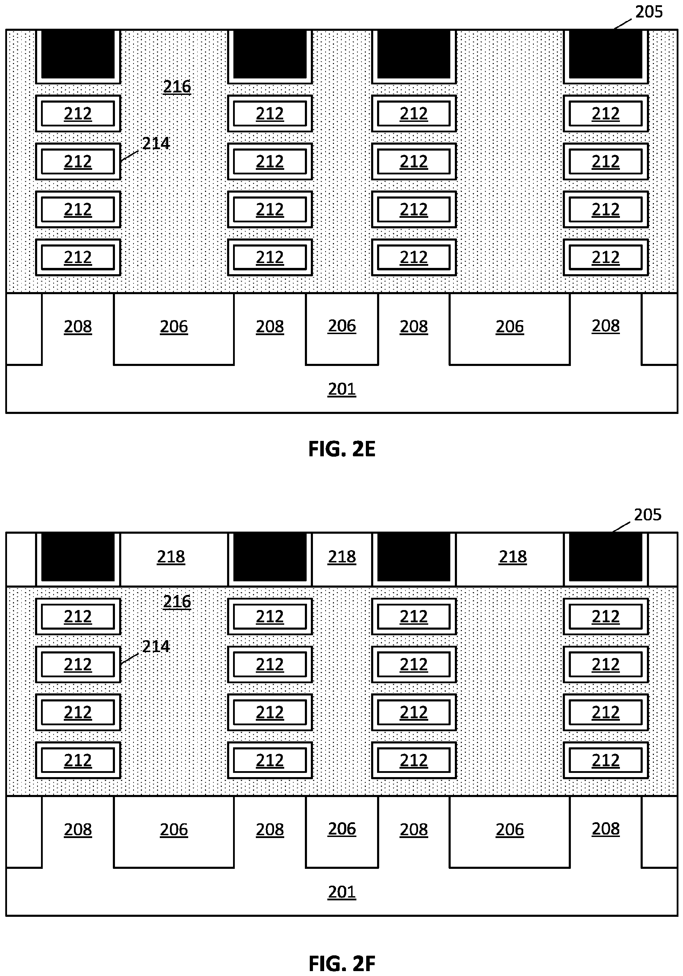

Figure 2E depicts the cross-section view of the structure shown in Figure 2D following the formation of a gate structure and subsequent polishing, according to some embodiments. The gate structure includes a gate dielectric 214 and a conductive gate electrode 216. Gate dielectric 214 may be first formed around nanoribbons 212 and cap layer 205 prior to the formation of gate electrode 216. The gate dielectric 214 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 214 includes a layer of hafnium oxide with a thickness between about 1 nm and about 5 nm. In some embodiments, gate dielectric 214 may include one or more silicates (e.g., titanium silicate, tungsten silicate, niobium silicate, and silicates of other transition metals). In some cases, gate dielectric 214 may include a first layer on nanoribbons 212, and a second layer on the first layer. The first layer can be, for instance, an oxide of the semiconductor material of nanoribbons 212 (e.g., silicon dioxide) and the second layer can be a high-k dielectric material (e.g., hafnium oxide). More generally, gate dielectric 214 can include any number of dielectric layers. According to some embodiments, gate dielectric 214 forms along all surfaces exposed within the gate trench, such as along inner sidewalls of the spacer structures, along the top surfaces of dielectric fill 206 and subfin regions 208, and along surfaces of cap layer 205.

As noted above, gate electrode 216 can represent any number of conductive layers. The conductive gate electrode 216 may be deposited using electroplating, electroless plating, CVD, PECVD, ALD, or PVD, to name a few examples. In some embodiments, gate electrode 216 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 216 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 216) is planar with the top surface of other semiconductor elements, such as the spacer structures that define the gate trench. In some embodiments, a top surface of gate electrode 216 is substantially coplanar with a top surface of cap layer 205. In some examples, masking can be used to facilitate processing of one gate structure type, while the locations of other gate structure types are masked off, and vice-versa.

Figure 2F depicts the cross-section view of the structure shown in Figure 2E following the recessing of gate electrode 216 and the formation of sacrificial layer 218, according to some embodiments. Gate electrode 216 may be recessed using any suitable isotropic etching process that selectively etches the metal material(s) of gate electrode 216. According to some embodiments, gate electrode 216 is recessed by a height that is substantially the same as a thickness of cap layer 205.

According to some embodiments, the recessed areas of gate electrode 216 between cap layer 205 are filled with sacrificial layer 218. A top surface of sacrificial layer 218 may be polished using, for example, chemical mechanical polishing (CMP) to be substantially coplanar with a top surface of cap layer 205. Sacrificial layer 218 may be, for example, amorphous silicon, titanium nitride, aluminum oxide, or any other suitable material that can be removed at a later time without damaging any surrounding transistor elements.

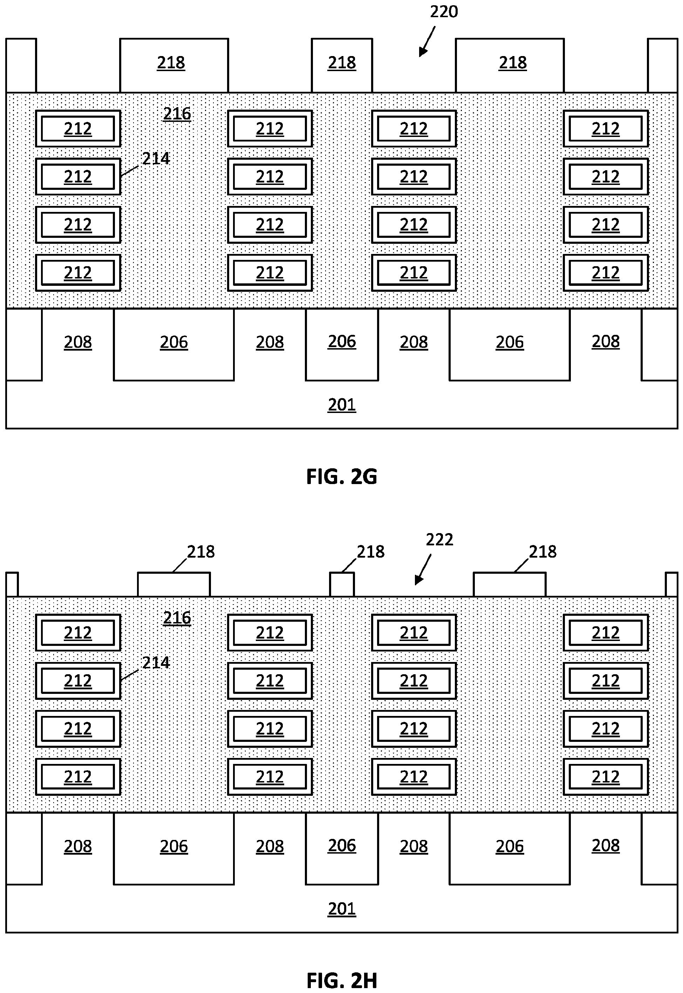

Figure 2G depicts the cross-section view of the structure shown in Figure 2F following the removal of cap layer 205 from between sacrificial layer 218, according to some embodiments. The removal of cap layer 205 forms recesses 220 through sacrificial layer 218. Recesses 220 are substantially aligned over each vertical set of nanoribbons 212, according to some embodiments. In some examples, any remaining portion of gate dielectric 214 remaining within recesses 220 following the removal of cap layer 205 are also removed using a suitable isotropic etching process.

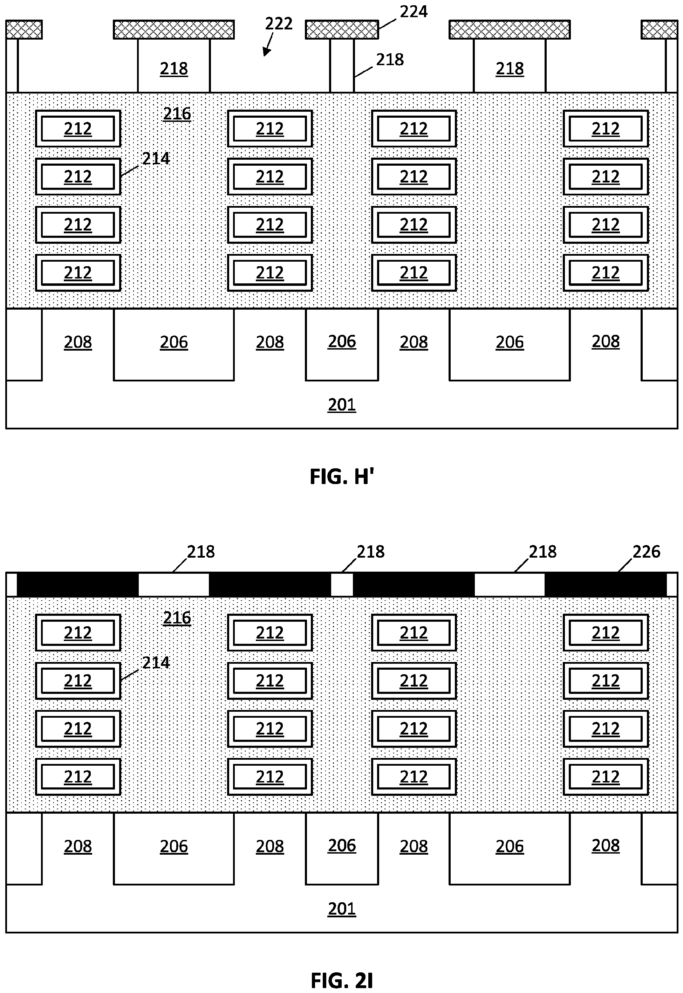

Figure 2H depicts the cross-section view of the structure shown in Figure 2G following a widening of recesses 220 to form widened recesses 222, according to some embodiments. Recesses 220 may be widened by isotropically etching sacrificial layer 218. For example, an atomic layer etching (ALE) process may be performed to etch all exposed surfaces of sacrificial layer 218 at substantially the same rate. Accordingly, the vertical thickness of sacrificial layer 218 may be reduced during the etching process, as well as the lateral thickness of sacrificial layer 218. Widened recesses 222 may have a width along the second direction that is at least 5%, at least 10%, at least 15%, at least 25%, or at least 50% greater than a width of recesses 220. According to some embodiments, the remaining portions of sacrificial layer 218 mark regions where openings are to be formed through the underlying gate electrode 216.

Other suitable techniques may be used to widen recesses 220. Figure 2H' illustrates another example process following the formation of recesses 220 to form widened recesses 222. In this example, helmet structures 224 are formed along the top surfaces of sacrificial layer 218 (e.g., as 218 is shown in Figure 2G) while exposing the sidewalls surfaces of sacrificial layer 218. Helmet structures 224 may be any suitable dielectric hard mask material formed using sputtering to form primarily on the top surfaces of sacrificial layer 218. Following the formation of helmet structures 224, an isotropic etching process can be used to laterally etch the sidewalls of sacrificial layer 218 to form widened recesses 222, as shown in Figure H'. The helmet structures 224 can then be removed (via selective etch or CMP).

Regardless of which technique is used to form widened recesses 222, Figure 2I illustrates another cross-section view of the structure shown in Figure 2H/2H' following the formation of mask structures 226 within widened recesses 222, according to some embodiments. Mask structures 226 may be any suitable dielectric material, such as silicon nitride or silicon oxynitride. According to some embodiments, the top surface of mask structures 226 is polished using, for example, CMP such that the top surface of mask structures 226 is substantially coplanar with a top surface of sacrificial layer 218. Due to the width and position of widened recesses 222, each of mask structures 226 is aligned over a corresponding set of nanoribbons 212 and is wider than nanoribbons 212.

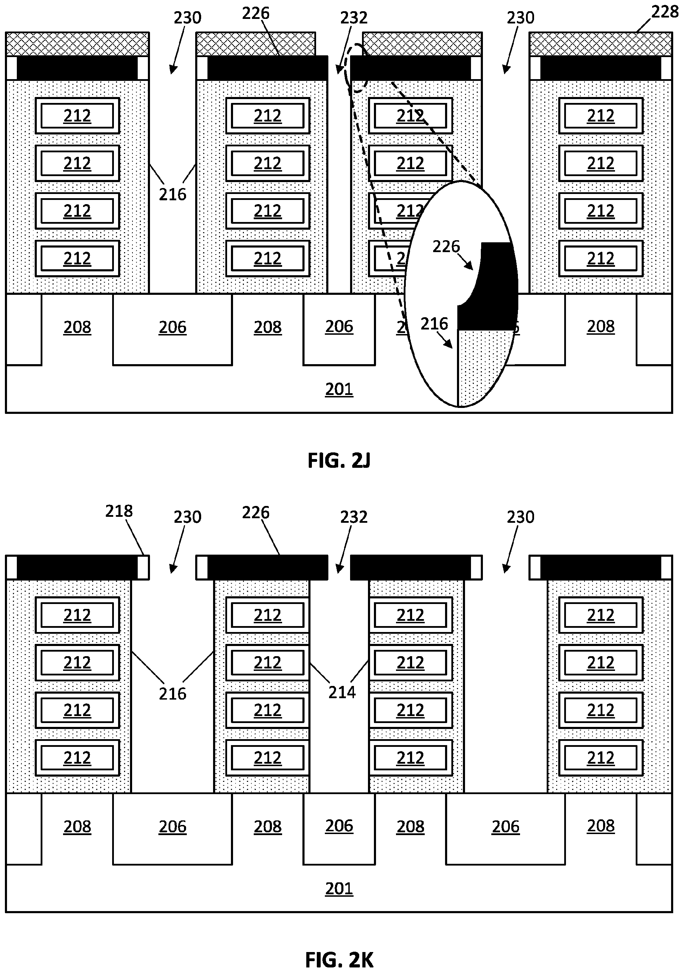

Figure 2J illustrates another cross-section view of the structure shown in Figure 2I following the formation of trench recesses 230 and 232, according to some embodiments. A mask layer 228 may be formed over the top surface of sacrificial layer 218 and mask structures 226 and subsequently patterned using any suitable lithography-based process to form openings through mask layer 228 at locations where trench recesses are to be formed. Exposed portions of sacrificial layer 218 within the openings through mask layer 228 may also be removed to expose the underlying gate electrode 216. According to some embodiments, mask structures 226 are not removed during the removal of portions of sacrificial layer 218, thus creating a smaller opening between the inner sets of nanoribbons 212.

Once the surface of gate electrode 216 is exposed within the various openings, a reactive ion etching (RIE) process may be performed to remove the metal material(s) of gate electrode 216. According to some embodiments, the anisotropic nature of the RIE process forms high-aspect ratio trenches that cut across the gate trench along the first direction. According to some embodiments, trench recess 230 is wider than trench recess 232 due to the additional masking of the RIE process caused by the presence of mask structures 226. Trench recess 232 is self-aligned at the midpoint (or other intermediate point) between the adjacent nanoribbons 212 of the middle two semiconductor devices since mask structures 226 determine the location of the opening between them rather than the alignment of mask layer 228.

Trench recess 230 may have a high height-to-width aspect ratio of 5:1 or more, such as between 6:1 and 10:1 and may be formed via a series of RIE and passivation steps to etch through the conductive material of gate electrode 216. Trench recess 232 may have a higher height-to-width aspect ratio compared to trench recess 230. Both trench recesses 230 and 232 may be tapered and have a largest width along a top surface of gate electrode 216. In some embodiments, trench recesses 230 and 232 extend at least partially through dielectric fill 206 or extend through an entire thickness of dielectric fill 206 and into the underlying substrate 102.

According to some embodiments, the RIE process used to form trench recess 232 also partially etches the exposed corners of mask structures 226, as shown in the blown-out illustration. The corners of mask structures 226 may be softened, rounded, or otherwise etched away, and in the example case shown leaving a concave divot along the edge of mask structures 226.

Figure 2K illustrates another cross-section view of the structure shown in Figure 2J following the widening of each of trench recesses 230 and 232, according to some embodiments. An isotropic metal ALE process may be used to selectively etch away the exposed sidewalls of gate electrode 216 within each of trench recesses 230 and 232. Any other suitable isotropic metal etching process can be used as well. According to some embodiments, trench recess 232 is widened until gate dielectric 214 is exposed around the edge of the adjacent nanoribbons 212. Trench recesses 230 are similarly widened by substantially the same amount as trench recess 232. Due to the distance between the devices on either side of trench recesses 230, no portion of gate dielectric 214 is exposed within trench recesses 230, according to some embodiments. Due to the selective etching of gate electrode 216 compared to other exposed dielectric materials, trench recesses 230 and 232 are widened beneath mask structures 226 such that portions of mask structures 226 extend over the widened trench recesses 230 and 232, according to some embodiments. To this end, the lateral distance between masking layers at the opening of the recess is smaller than the lateral distance between the opposing sidewalls of the etched gate structures.

Figure 2L illustrates another cross-section view of the structure shown in Figure 2K following the formation of gate cuts 234 within trench recesses 230 and a dielectric spine 236 within trench recess 232, according to some embodiments. Both gate cuts 234 and dielectric spine 236 may be formed simultaneously using the same dielectric deposition process(es). In some examples, both gate cuts 234 and dielectric spine 236 include a high-k dielectric material, such as silicon nitride, that is deposited first within the corresponding trench recesses. The high-k material may completely fill the recesses such that gate cuts 234 and dielectric spine 236 each include only silicon nitride or another suitable high-k dielectric material. In some examples, a first high-k dielectric layer is conformally deposited followed by a low-k dielectric material fill, such as silicon dioxide, within a remaining portion of the recesses. In such examples, gate cuts 234 and dielectric spine 236 may include a high-k dielectric outer layer and a low-k dielectric core. Note that the nanoribbons on either side of dielectric spine 236 are now part of a forksheet structure and thus are re-identified as nanosheets 238. Dielectric spine 236 may have a first width w₁ along the second direction between nanosheets 238 that is between about 15 nm and about 25 nm, and may have a second width w₂ along the second direction between mask structures 226 that is between about 5 nm and about 15 nm.

Regardless of how many dielectric deposition processes are used to form gate cuts 234 and dielectric spine 236, any excess dielectric deposition outside of the recesses may be polished away to planarize the top surface of the structure. Also, any remaining portions of sacrificial layer 218 may be removed using any suitable isotropic etching process and replaced with a dielectric layer 240. Dielectric layer 240 may include any suitable dielectric material, such as the same dielectric material as mask structures 226.

Due to the narrow opening at the top of trench recess 232, the process of forming dielectric material within the recess may pinch off at the narrow opening before filling the entire volume of trench recess 232. Figure 2L' illustrates an example where an airgap 242 is formed within a central portion of dielectric spine 236. Airgap 242 may be formed when the deposition of dielectric material along the sides of trench recess 232 pinches off at the narrow opening between mask structures 226. According to some embodiments, airgap 242 includes an inert gas, such as argon, or may be devoid of any appreciable gas (e.g., a vacuum).

Figure 2L" illustrates another example of the structure shown in Figure 2L where gate cuts 234 and dielectric spine 236 each include tail structures 244 that extend into dielectric fill 206. Tail structures 244 may be formed from the initial RIE etch process that forms trench recesses 230 and 232 and extends beyond gate electrode 216 into dielectric fill 206. Afterwards, the widening of gate electrode 216 within trench recesses 230 and 232 does not appreciably etch dielectric fill 206, thus maintaining the narrower width of the openings through dielectric fill 206. Tail structures 244 may include the same dielectric material(s) as the remainder of both gate cuts 234 and dielectric spine 236.

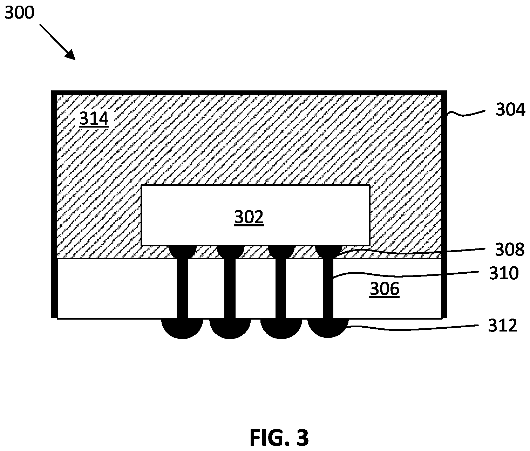

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

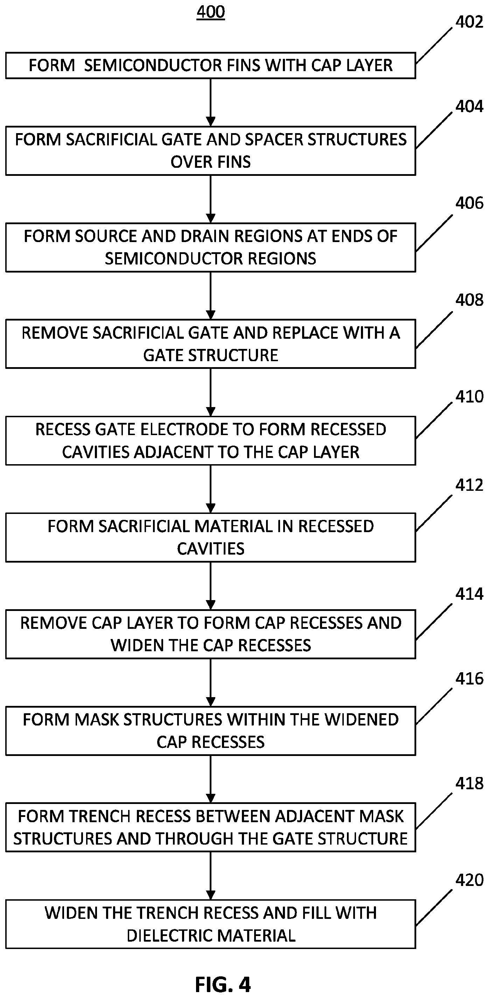

Figure 4 is a flow chart of a method 400 for forming at least a portion of an integrated circuit, according to an embodiment. Various operations of method 400 may be illustrated in Figures 2A - 2L. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe all processes that are performed to form common transistor structures. Some of the operations of method 400 may be performed in a different order than the illustrated order.

Method 400 begins with operation 402 where at least two parallel semiconductor fins are formed, according to some embodiments. According to some embodiments, the fins include alternating layers of material (e.g., alternating layers of silicon and SiGe) that facilitates forming of nanoribbons and nanosheets during a gate forming process where one type of the alternating layers are selectively etched away so as to liberate the other type of alternating layers within the channel region, so that gate-all-around (GAA) and forksheet processes can be carried out. The alternating layers can be blanket deposited and then etched into fins, or deposited into fin-shaped trenches. According to some embodiments, the fins also include a cap layer over each fin that may be used as a hard mask to define the locations of the fins during, for example, an RIE process. The cap layer may be a dielectric material, such as silicon nitride. This cap layer remains over the fins up through at least the formation of gate structures over the fins, according to some embodiments.

According to some embodiments, a dielectric layer is formed around subfin portions of the fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 400 continues with operation 404 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 400 continues with operation 406 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some examples, internal gates spacers are formed by way of the source drain recesses, prior to epitaxial growth of the source and drain regions. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 400 continues with operation 408 where the sacrificial gate is removed and replaced with a gate structure. The sacrificial gate may be removed using an isotropic etching process that selectively removes all of the material from the sacrificial gate, thus exposing the various fins between the set of spacer structures. According to some embodiments, any sacrificial layers within the exposed fins between the spacer structures may also be removed to release nanoribbons or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples.

Method 400 continues with operation 410 where the gate electrode is recessed. According to some embodiments, the gate electrode may be recessed to form cavities adjacent to the cap layer present above each set of nanoribbons. The gate electrode may be recessed using any suitable isotropic etching process that selectively etches the metal material(s) of the gate electrode. According to some embodiments, the gate electrode is recessed down to a plane that is substantially coplanar with a bottom surface of the cap layer.

Method 400 continues with operation 412 where a sacrificial material is formed within the cavities. A top surface of the sacrificial material may be polished using, for example, CMP to be substantially coplanar with a top surface of the cap layer. The sacrificial layer may be amorphous silicon, titanium nitride, aluminum oxide, or any other suitable material that can be removed at a later time without damaging any surrounding transistor elements.

Method 400 continues with operation 414 where the cap layer is removed to form cap recesses and the cap recesses are subsequently widened. Any suitable isotropic etching process may be used to selectively remove the dielectric cap layer material while the sacrificial layer is maintained. Cap recesses are left behind in the regions between the sacrificial layer where the cap layer had been. Accordingly, the cap recesses may be aligned over each set of nanoribbons.

According to some embodiments, the cap recesses are widened by laterally etching the sacrificial layer. In some examples, an ALE process is used to isotropically etch all exposed surfaces of the sacrificial layer and widen the cap recesses. In some examples, dielectric helmet structures are formed on the top surface of the sacrificial layer while exposing the sidewalls of the sacrificial layer to a suitable isotropic etching process. The cap recesses may be widened to increase the width by at least 5%, at least 10%, at least 15%, at least 25%, or at least 50%.

Method 400 continues with operation 416 where mask structures are formed within the widened cap recesses between the sacrificial layer. The mask structures may be any suitable dielectric material, such as silicon nitride or silicon oxynitride. According to some embodiments, the top surface of the mask structures is polished using, for example, CMP such that the top surface of the mask structures is substantially coplanar with a top surface of the sacrificial layer. Due to the width and position of the widened cap recesses, each of the mask structures is aligned over a corresponding set of nanoribbons and is wider than the underlying nanoribbons, according to some embodiments.

Method 400 continues with operation 418 where a trench recess is formed through the gate electrode and between adjacent mask structures. The trench recess is self-aligned at a midpoint between adjacent semiconductor devices due to the mask structures. The trench recess may have a high height-to-width aspect ratio of 8:1 or more and may be formed via a series of RIE and passivation steps to etch through the conductive material of the gate electrode. The trench recess may be tapered and have a largest width along a top surface of the gate electrode. In some embodiments, the trench recess extends at least partially through the dielectric layer at the base of the fins or extends through an entire thickness of the dielectric layer and into a portion of the underlying substrate.

Method 400 continues with operation 420 where the trench recess is widened and at least partially filled with dielectric material to form a dielectric spine between neighboring semiconductor devices. An isotropic metal ALE process may be used to selectively etch away the exposed sidewalls of the gate electrode within the trench recess. Any other suitable isotropic metal etching process can be used as well. According to some embodiments, the trench recess is widened until a gate dielectric around the edges of the neighboring nanoribbons is exposed. Due to the selective etching of the gate electrode compared to the mask structures, the trench recess is widened beneath the mask structures such that portions of the mask structures extend over the widened trench recess, according to some embodiments.

One or more dielectric materials may be formed within the widened trench recess to complete the formation of the dielectric spine. In some examples, the dielectric materials include at least silicon nitride. In some examples, an airgap may be present within a central portion of the dielectric spine.

### Example System

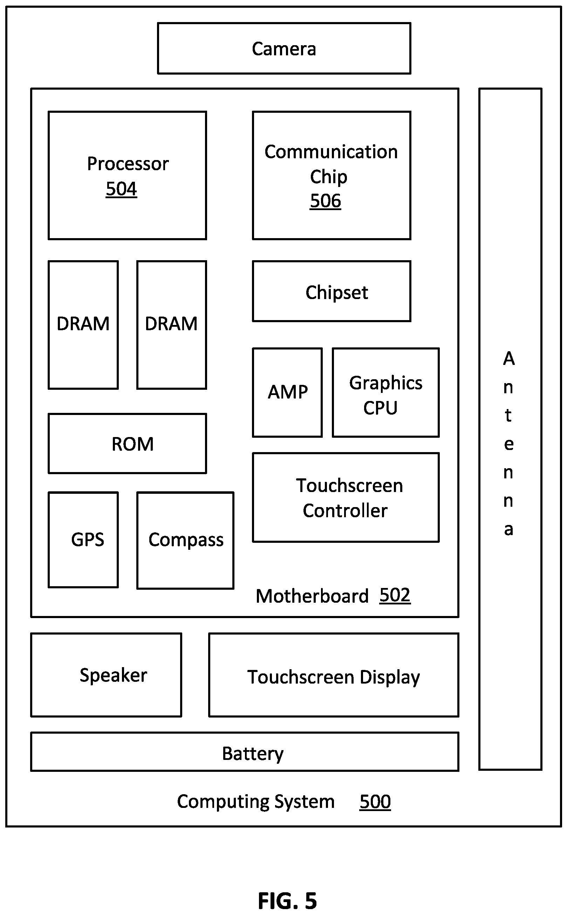

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment, such as a module including an integrated circuit on a substrate, the substrate having forksheet transistor structures as variously described herein. In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multistandard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device and a second semiconductor device. The first semiconductor device has a first semiconductor material extending in a first direction between a first source or drain region and a second source or drain region, and a first gate structure extending in a second direction over the first semiconductor region. The second semiconductor device has a second semiconductor region extending in the first direction between a third source or drain region and a fourth source or drain region, and a second gate structure extending in the second direction over the second semiconductor region. The integrated circuit further includes a first dielectric structure above the first semiconductor material, a second dielectric structure above the second semiconductor material, and a dielectric spine between the first semiconductor material and the second semiconductor material and between the first gate structure and the second gate structure. The dielectric spine is also between the first mask structure and the second mask structure, and the dielectric spine contacts at least a portion of a lower surface of the first dielectric structure and at least a portion of a lower surface of the second dielectric structure.

Example 2 includes the integrated circuit of Example 1, wherein the first semiconductor material comprises first one or more semiconductor nanosheets, and the second semiconductor material comprises second one or more semiconductor nanosheets.

Example 3 includes the integrated circuit of Example 2, wherein the first one or more semiconductor nanosheets and the second one or more semiconductor nanosheets comprise germanium, silicon, or both.

Example 4 includes the integrated circuit of any one of Examples 1-3, wherein the dielectric spine comprises silicon and nitrogen.

Example 5 includes the integrated circuit of any one of Examples 1-4, wherein the first semiconductor device further comprises a first gate dielectric around the first semiconductor material, and the second semiconductor device further comprises a second gate dielectric around the second semiconductor material.

Example 6 includes the integrated circuit of Example 5, wherein the first gate dielectric is directly between the first semiconductor material and the dielectric spine, and the second gate dielectric is directly between the second semiconductor material and the dielectric spine.

Example 7 includes the integrated circuit of Example 5 or 6, wherein the first gate dielectric and the second gate dielectric each comprise a high-k dielectric material.

Example 8 includes the integrated circuit of any one of Examples 1-7, wherein the first dielectric structure has a greater width than the first semiconductor material along the second direction, and the second dielectric structure has a greater width than the second semiconductor material along the second direction.

Example 9 includes the integrated circuit of Example 8, wherein each of the first and second dielectric structures has a width along the second direction between about 25 nm and about 35 nm.

Example 10 includes the integrated circuit of any one of Examples 1-9, wherein each of the first and second dielectric structures comprises silicon and nitrogen.

Example 11 includes the integrated circuit of any one of Examples 1-10, wherein the dielectric spine has a first width along the second direction between the first dielectric structure and second dielectric structure, and a second width between the first semiconductor material and second semiconductor material, the second width being greater than the first width.

Example 12 includes the integrated circuit of Example 11, wherein the first width is between about 5 nm and about 15 nm, and the second width is between about 15 nm and about 25 nm.

Example 13 includes the integrated circuit of any one of Examples 1-12, wherein the dielectric spine comprises an airgap within a central portion of the dielectric spine.

Example 14 is a printed circuit board comprising the integrated circuit of any one of Examples 1-13.

Example 15 is an electronic device having a chip package with one or more dies. At least one of the one or more dies includes a first semiconductor device having a first semiconductor material extending in a first direction between a first source or drain region and a second source or drain region and a first gate structure extending in a second direction over the first semiconductor material, a second semiconductor device having a second semiconductor material extending in the first direction between a third source or drain region and a fourth source or drain region and a second gate structure extending in the second direction over the second semiconductor material, a first mask structure above the first semiconductor material, a second mask structure above the second semiconductor material, and a dielectric spine between the first semiconductor material and the second semiconductor material and between the first gate structure and the second gate structure. The dielectric spine is also between the first mask structure and the second mask structure, and the dielectric spine contacts at least a portion of a lower surface of the first mask structure and at least a portion of a lower surface of the second mask structure.

Example 16 includes the electronic device of Example 15, wherein the first semiconductor material comprises first one or more semiconductor nanosheets, and the second semiconductor material comprises second one or more semiconductor nanosheets.

Example 17 includes the electronic device of Example 16, wherein the first one or more semiconductor nanosheets and the second one or more semiconductor nanosheets comprise germanium, silicon, or both.

Example 18 includes the electronic device of any one of Examples 15-17, wherein the dielectric spine comprises silicon and nitrogen.

Example 19 includes the electronic device of any one of Examples 15-18, wherein the first semiconductor device further comprises a first gate dielectric around the first semiconductor material and the second semiconductor device further comprises a second gate dielectric around the second semiconductor material.

Example 20 includes the electronic device of Example 19, wherein the first gate dielectric is directly between the first semiconductor material and the dielectric spine, and the second gate dielectric is directly between the second semiconductor material and the dielectric spine.

Example 21 includes the electronic device of Example 19 or 20, wherein the first gate dielectric and the second gate dielectric each comprise a high-k dielectric material.

Example 22 includes the electronic device of any one of Examples 15-21, wherein the first mask structure has a greater width than the first semiconductor material along the second direction, and the second mask structure has a greater width than the second semiconductor material along the second direction.

Example 23 includes the electronic device of Example 22, wherein each of the first and second mask structures has a width along the second direction between about 25 nm and about 35 nm.

Example 24 includes the electronic device of any one of Examples 15-23, wherein each of the first and second mask structures comprises silicon and nitrogen.

Example 25 includes the electronic device of any one of Examples 15-24, wherein the dielectric spine has a first width along the second direction between the first mask structure and second mask structure, and a second width between the first semiconductor material and second semiconductor material, the second width being greater than the first width.

Example 26 includes the electronic device of Example 25, wherein the first width is between about 5 nm and about 15 nm, and the second width is between about 15 nm and about 25 nm.

Example 27 includes the electronic device of any one of Examples 15-26, wherein the dielectric spine comprises an airgap within a central portion of the dielectric spine.

Example 28 includes the electronic device of any one of Examples 15-27, further comprising a printed circuit board, wherein the chip package is attached to the printed circuit board.

Example 29 is a method of forming an integrated circuit. The method includes forming a first fin comprising first semiconductor material and a first dielectric cap over the first semiconductor material, and a second fin comprising second semiconductor material and a second dielectric cap over the second semiconductor material, wherein the first fin and the second fin are adjacent and extend parallel to one another along a first direction; forming a sacrificial gate over the first fin and the second fin along a second direction different from the first direction; forming first source or drain regions at opposite ends of the first fin and second source or drain regions at opposite ends of the second fin; replacing the sacrificial gate with a gate structure that extends over the first semiconductor material and the second semiconductor material along the second direction; recessing a top surface of the gate structure to form a recessed cavity adjacent to the first dielectric cap and second dielectric cap; forming a sacrificial material within the recessed cavity; removing the first dielectric cap and second dielectric cap to form first and second recesses respectively; widening the first and second recesses to form first and second widened recesses respectively; forming first and second mask structures within the first and second widened recesses respectively; forming a trench recess between the first and second mask structures and through the gate structure between the first semiconductor material and the second semiconductor material; widening the trench recess between the first semiconductor material and the second semiconductor material; and filling the trench recess with one or more dielectric materials.

Example 30 includes the method of Example 29, wherein forming the sacrificial material comprises depositing amorphous silicon or depositing a material comprising titanium and nitrogen in the recessed cavity.

Example 31 includes the method of Example 29 or 30, wherein each of the first and second mask structures comprise silicon and nitrogen.

Example 32 includes the method of any one of Examples 29-31, wherein widening the first and second recesses comprises widening the first and second recesses using an atomic layer etch process.

Example 33 includes the method of any one of Examples 29-32, wherein the first fin comprises first sacrificial material alternating with the first semiconductor material and the second fin comprises second sacrificial material alternating with the second semiconductor material, wherein the method further comprises removing the first sacrificial material and the second sacrificial material.

Example 34 is an integrated circuit that includes a first semiconductor material extending in a first direction from a first source or drain region to a second source or drain region, a first gate structure extending in a second direction over the first semiconductor material, a second semiconductor material extending in the first direction from a third source or drain region to a fourth source or drain region, a second gate structure extending in the second direction over the second semiconductor material, and a dielectric spine between the first semiconductor material and the second semiconductor material and between the first gate structure and the second gate structure. The first gate structure includes a first gate dielectric on the first semiconductor material and a first gate electrode on the first gate dielectric, and the second gate structure includes a second gate dielectric on the second semiconductor material and a second gate electrode on the second gate dielectric. The first gate dielectric is directly between the dielectric spine and the first semiconductor material, and the second gate dielectric is directly between the dielectric spine and the second semiconductor material.

Example 35 includes the integrated circuit of Example 34, wherein the first semiconductor material comprises first one or more semiconductor nanosheets, and the second semiconductor material comprises second one or more semiconductor nanosheets.

Example 36 includes the integrated circuit of Example 35, wherein the first one or more semiconductor nanosheets and the second one or more semiconductor nanosheets comprise germanium, silicon, or both.

Example 37 includes the integrated circuit of any one of Examples 34-36, wherein the dielectric spine comprises silicon and nitrogen.

Example 38 includes the integrated circuit of any one of Examples 34-37, wherein the first gate dielectric and the second gate dielectric each comprise a high-k dielectric material.

Example 39 includes the integrated circuit of any one of Examples 34-38, further comprising a first dielectric structure over the first semiconductor material and a second dielectric structure over the second semiconductor material, wherein the dielectric spine is also between the first dielectric structure and the second dielectric structure.

Example 40 includes the integrated circuit of Example 39, wherein each of the first and second dielectric structures has a width along the second direction between about 25 nm and about 35 nm.

Example 41 includes the integrated circuit of Example 39 or 40, wherein each of the first and second dielectric structures comprises silicon and nitrogen.

Example 42 includes the integrated circuit of any one of Examples 39-41, wherein the dielectric spine has a first width along the second direction between the first dielectric structure and second dielectric structure, and a second width between the first semiconductor material and second semiconductor material, the second width being greater than the first width.

Example 43 includes the integrated circuit of Example 42, wherein the first width is between about 5 nm and about 15 nm, and the second width is between about 15 nm and about 25 nm.

Example 44 includes the integrated circuit of any one of Examples 34-43, wherein the dielectric spine comprises an airgap within the dielectric spine.

Example 45 is a printed circuit board comprising the integrated circuit of any one of Examples 34-44.

Example 46 is an integrated circuit that includes a first semiconductor material extending in a first direction from a first source or drain region to a second source or drain region, a first gate structure extending in a second direction over the first semiconductor material, a second semiconductor material extending in the first direction from a third source or drain region to a fourth source or drain region, a second gate structure extending in the second direction over the second semiconductor material, and a dielectric spine between the first semiconductor material and the second semiconductor material and between the first gate structure and the second gate structure. The first gate structure includes a first gate dielectric on the first semiconductor material and a first gate electrode on the first gate dielectric. The second gate structure includes a second gate dielectric on the second semiconductor material and a second gate electrode on the second gate dielectric. The dielectric spine has first and second widths each extending in the second direction with the first width being an upper most width and the second width being a width between the first gate structure and the second gate structure. The first width is at least 5 nm smaller than the second width.

Example 47 includes the integrated circuit of Example 46, wherein the first semiconductor material comprises first one or more semiconductor nanosheets, and the second semiconductor material comprises second one or more semiconductor nanosheets.

Example 48 includes the integrated circuit of Example 47, wherein the first one or more semiconductor nanosheets and the second one or more semiconductor nanosheets comprise germanium, silicon, or both.

Example 49 includes the integrated circuit of any one of Examples 46-48, wherein the dielectric spine comprises silicon and nitrogen.

Example 50 includes the integrated circuit of any one of Examples 46-49, wherein the first gate dielectric and the second gate dielectric each comprise a high-k dielectric material.

Example 51 includes the integrated circuit of any one of Examples 46-50, further comprising a first dielectric structure over the first semiconductor material and a second dielectric structure over the second semiconductor material, wherein the first width of the dielectric spine is between the first dielectric structure and the second dielectric structure.

Example 52 includes the integrated circuit of Example 51, wherein each of the first and second dielectric structures has a width along the second direction between about 25 nm and about 35 nm.

Example 53 includes the integrated circuit of Example 51 or 52, wherein each of the first and second dielectric structures comprises silicon and nitrogen.

Example 54 includes the integrated circuit of any one of Examples 46-53, wherein the first width is between about 5 nm and about 15 nm, and the second width is between about 15 nm and about 25 nm.

Example 55 includes the integrated circuit of any one of Examples 46-54, wherein the dielectric spine comprises an airgap within the dielectric spine.

Example 56 is a printed circuit board comprising the integrated circuit of any one of Examples 46-55.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor material extending in a first direction between a first source or drain region and a second source or drain region, and a first gate structure extending in a second direction over the first semiconductor material;
a second semiconductor device having a second semiconductor material extending in the first direction between a third source or drain region and a fourth source or drain region, and a second gate structure extending in the second direction over the second semiconductor material;
a first dielectric structure above the first semiconductor material;
a second dielectric structure above the second semiconductor material; and
a dielectric spine between the first semiconductor material and the second semiconductor material and between the first gate structure and the second gate structure, wherein the dielectric spine is also between the first dielectric structure and the second dielectric structure and wherein the dielectric spine contacts at least a portion of a lower surface of the first dielectric structure and at least a portion of a lower surface of the second dielectric structure.

2. The integrated circuit of claim 1, wherein the first semiconductor material comprises first one or more semiconductor nanosheets, and the second semiconductor material comprises second one or more semiconductor nanosheets.

3. The integrated circuit of claim 2, wherein the first one or more semiconductor nanosheets and the second one or more semiconductor nanosheets comprise germanium, silicon, or both.

4. The integrated circuit of any one of claims 1 through 3, wherein the dielectric spine comprises silicon and nitrogen.

5. The integrated circuit of any one of claims 1 through 4, wherein the first semiconductor device further comprises a first gate dielectric around the first semiconductor material, and the second semiconductor device further comprises a second gate dielectric around the second semiconductor material.

6. The integrated circuit of claim 5, wherein the first gate dielectric is directly between the first semiconductor material and the dielectric spine, and the second gate dielectric is directly between the second semiconductor material and the dielectric spine.

7. The integrated circuit of claim 5 or 6, wherein the first gate dielectric and the second gate dielectric each comprise a high-k dielectric material.

8. The integrated circuit of any one of claims 1 through 7, wherein the first dielectric structure has a greater width than the first semiconductor material along the second direction, and the second dielectric structure has a greater width than the second semiconductor material along the second direction.

9. The integrated circuit of claim 8, wherein each of the first and second dielectric structures has a width along the second direction between about 25 nm and about 35 nm.

10. The integrated circuit of any one of claims 1 through 9, wherein each of the first and second dielectric structures comprises silicon and nitrogen.

11. The integrated circuit of any one of claims 1 through 10, wherein the dielectric spine has a first width along the second direction between the first dielectric structure and second dielectric structure, and a second width between the first semiconductor material and second semiconductor material, the second width being greater than the first width.

12. The integrated circuit of claim 11, wherein the first width is between about 5 nm and about 15 nm, and the second width is between about 15 nm and about 25 nm.

13. The integrated circuit of any one of claims 1 through 12, wherein the dielectric spine comprises an airgap within a central portion of the dielectric spine.

14. A printed circuit board comprising the integrated circuit of any one of claims 1 through 13.

15. A method of forming an integrated circuit, the method comprising:
forming a first fin comprising first semiconductor material and a first dielectric cap over the first semiconductor material, and a second fin comprising second semiconductor material and a second dielectric cap over the second semiconductor material, wherein the first fin and the second fin are adjacent and extend parallel to one another along a first direction;
forming a sacrificial gate over the first fin and the second fin along a second direction different from the first direction;
forming first source or drain regions at opposite ends of the first fin and second source or drain regions at opposite ends of the second fin;
replacing the sacrificial gate with a gate structure that extends over the first semiconductor material and the second semiconductor material along the second direction;
recessing a top surface of the gate structure to form a recessed cavity adjacent to the first dielectric cap and second dielectric cap;
forming a sacrificial material within the recessed cavity; removing the first dielectric cap and second dielectric cap to form first and second recesses respectively;
widening the first and second recesses to form first and second widened recesses respectively;
forming first and second mask structures within the first and second widened recesses respectively;
forming a trench recess between the first and second mask structures and through the gate structure between the first semiconductor material and the second semiconductor material;
widening the trench recess between the first semiconductor material and the second semiconductor material; and
filling the trench recess with one or more dielectric materials.
